# EUROPEAN PATENT APPLICATION

(11) **EP 3 316 596 A1**
(43) Date of publication of application: **02.05.2018**
(21) Application number: 15897026.9
(22) Date of filing: 08.12.2015
(51) Int. Cl.: H04R 9/06, H04R 9/02

(54) **LOUDSPEAKER STRUCTURE**

(30) Priority: 29.06.2015 CN 201510368258
(71) Applicant: GOERTEK.INC, Hi-Tech Industry District Weifang Shandong 261031 (CN)
(72) Inventor: DONG, Wenqiang, Weifang Shandong 261031 (CN); XING, Mingxing, Weifang Shandong 261031 (CN)
(74) Representative: Cabinet Bleger-Rhein-Poupon
(86) International application number: PCT/CN2015/096714
(87) International publication number: WO 2017/000499

(57) **Abstract**

The present invention discloses a speaker structure, including a vibration assembly, a magnetic circuit system, a speaker housing and shields, wherein the speaker housing is configured to carry the vibration assembly and the magnetic circuit system; the shields are disposed on the speaker housing; the shields are made of a magnetically conductive material to form a magnetic shield surrounding the speaker structure; and the shield may be embedded inside the speaker housing and/or mounted on an outer surface of the speaker housing. The speaker structure provided by the present invention can effectively prevent a magnetic flux leakage phenomenon without affecting its sound performance; and meanwhile, the shields do not additionally occupy a space inside an electronic device where it is mounted.

## Description

### FIELD OF THE INVENTION

The present invention relates to the field of electro-acoustic transducers, and in particular, to a structural feature of a miniature speaker apparatus.

### BACKGROUND OF THE INVENTION

Mobile electronic devices such as mobile phones and tablet computers have become indispensable necessities in modern life, which usually have functions of playing sounds, interworking for communication, capturing images and the like. With the development of the mobile electronic devices, the mobile phones and the tablet computers gradually have a stronger sound performance, and are developed towards smaller and thinner ones, with smaller distances between components. A miniature speaker in the mobile electronic devices typically adopts a moving-coil speaker to produce a sound through an electromagnetic action. However, the moving-coil speaker usually has a magnetic flux leakage phenomenon, and a magnetic field generated by a magnetic circuit system radiates outside a speaker structure, resulting in an impact on other components such as an antenna and a camera in the electronic devices. When the miniature speaker adopts a multi-magnetic circuit system, the magnetic field is stronger, so that it more easily affects the other components.

In the prior art, the speaker structure is prevented from affecting the other components commonly by adopting the following two methods: firstly an additional magnetically conductive material is provided around the speaker structure or inside the electronic device to form a magnetic shield, which prevents the magnetic field of the speaker structure from radiating outwards. However, a space inside the electronic device is very limited, so that additional space inside the electronic device is occupied, resulting in changes in volume and shape of the entire electronic device; and secondly, the magnetism of the magnetic circuit system of the speaker is reduced. However, reducing the performance of the magnetic circuit system may affect the sound quality and the sound volume of the speaker structure.

Therefore, it is necessary to provide a novel technical solution for preventing a magnetic flux from leaking, which can not only improve the magnetic flux leakage phenomenon of the moving-coil speaker, but also can try to avoid additionally occupying the space inside the electronic device, while the performance of the miniature speaker may not be affected.

### SUMMARY OF THE INVENTION

The present invention is directed to provide a technical solution which can effectively prevent a speaker structure from leaking a magnetic flux.

According to a first aspect of the present invention, there is provided a speaker structure, including:
a vibration assembly;
a magnetic circuit system;
a speaker housing, which is configured to carry the vibration assembly and the magnetic circuit system; and
shields, which are disposed on the speaker housing, wherein
the shields are formed of a magnetically conductive material to form a magnetic shield around the speaker structure.

The shields may be embedded inside the speaker housing and/or mounted on an outer surface of the speaker housing.

The speaker housing may constitute side walls surrounding the speaker structure, and the shields may also be embedded inside the side walls and/or mounted on outer surfaces of the side walls.

Optionally, the shields may be of a rectangular sheet-like structure, and the shields may be made of an SPCC material.

In particular, the shields are made of an SPCC material.

In addition, the vibration assembly may include:
a diaphragm, edges of which are mounted on the speaker housing;
a voice coil, which includes a lead and a vibration ring, wherein the vibration ring is fixedly connected to the diaphragm; and
a composite layer, which is mounted on the diaphragm, wherein
the lead is mounted on the speaker housing to suspend the vibration ring in the speaker housing.

The magnetic circuit system may include:
a center magnet;
a center washer, which is mounted on the center magnet; and
a basin frame, which is configured to carry the center magnet and the central washer, wherein the basin frame is fixedly connected to the speaker housing.

Optionally, the speaker structure may further include a front cover fixedly mounted on the speaker housing to enclose the vibration assembly in the speaker housing. More preferably, the front cover may be made of a magnetically conductive material.

The speaker structure provided by the present invention can effectively prevent the magnetic field generated by the magnetic circuit system from leaking out of the speaker structure by utilizing a magnetic shielding effect. Compared with other prior arts of utilizing the magnetic shielding effect, the shields of the present invention are disposed on the speaker housing, and can limit a radiation range of the magnetic field more effectively. In addition, the shields of the present invention may be embedded inside the speaker housing to avoid additionally occupying a space due to the provision of the shields. Since the space inside the electronic device is very limited, the speaker structure of the present invention is capable of effectively preventing the magnetic flux from leaking without affecting the performance of the speaker itself and without occupying the space inside the electronic device, and the speaker structure of the present invention can achieve a remarkable technical effect.

Further features of the present invention and advantages thereof will become apparent from the following detailed description of exemplary embodiments according to the present invention with reference to the attached drawings.

### BRIEF DESCRIPTION OF THE DRAWINGS

The accompanying drawings, which are incorporated in and constitute a part of the specification, illustrate embodiments of the present invention and, together with the description thereof, serve to explain the principles of the present invention.
FIG. 1 is a side sectional view of a speaker housing according to a specific embodiment of the present invention;
FIG. 2 is an exploded view of a speaker housing and shields according to a specific embodiment of the present invention;
FIG. 3 is a construction view of a speaker housing according to a specific embodiment of the present invention;
FIG. 4 is an exploded view of parts of a speaker structure according to a specific embodiment of the present invention;
FIG. 5 is a side sectional view of a speaker structure according to a specific embodiment of the present invention; and
FIG. 6 is a construction view of a speaker structure according to a specific embodiment of the present invention.

### DETAILED DESCRIPTION OF THE EMBODIMENTS

Various exemplary embodiments of the present invention will now be described in detail with reference to the drawings. It should be noted that the relative arrangement of the components and steps, the numerical expressions, and numerical values set forth in these embodiments do not limit the scope of the present invention unless it is specifically stated otherwise.

The following description of at least one exemplary embodiment is merely illustrative in nature and is in no way intended to limit the invention, its application, or uses.

Techniques, methods and apparatus as known by one of ordinary skill in the relevant art may not be discussed in detail but are intended to be part of the specification where appropriate.

In all of the examples illustrated and discussed herein, any specific values should be interpreted to be illustrative only and non-limiting. Thus, other examples of the exemplary embodiments could have different values.

Notice that similar reference numerals and letters refer to similar items in the following figures, and thus once an item is defined in one figure, it is possible that it does not need to be further discussed in the followed figures.

The present invention provides a speaker structure including a vibration assembly, a magnetic circuit system, a speaker housing, and shields, wherein the vibration assembly and the magnetic circuit system are mounted inside the speaker housing, and the vibration assembly produces a sound by vibration under an action of a magnetic field generated by the magnetic circuit system. The shields are mounted on the speaker housing and made of a magnetically conductive material, which are capable of, according to a magnetic shielding principle, generating a magnetic shielding effect around the speaker structure, changing magnetic lines of the magnetic field generated by the magnetic circuit system, and preventing the magnetic field from being radiated outside the speaker structure. Optionally, in order to form a better magnetic shielding effect, the shields may be formed around the magnetic circuit system without being in direct contact with the magnetic circuit system. Compared with the magnetically conductive material disposed in the electronic device in the prior art, which is used to form a magnetic shield, the shields of the present invention are disposed on the speaker housing, thereby minimizing a need for the shields to additionally occupy a space in the electronic device. Moreover, the magnetic shielding effect can effectively prevent the magnetic flux leakage phenomenon, so as to prevent the magnetic field from affecting the components of other electronic devices around the speaker structure.

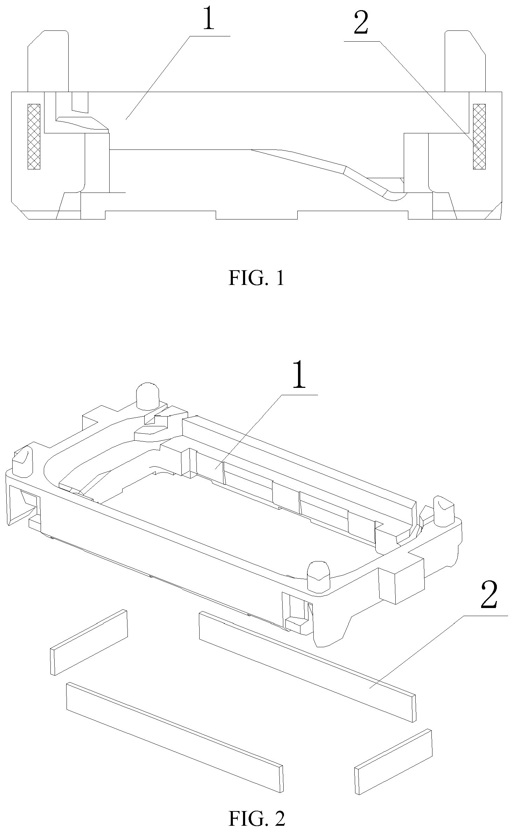

In particular, as shown in FIG. 1, in one embodiment of the present invention, the shields 2 may be embedded inside the speaker housing 1. The speaker housing 1 is typically made of a plastic material and may be made by injection molding, and the shields 2 may be disposed in an injection mold in advance and injection-molded inside the speaker structure. In the embodiment shown in FIG. 1, the overall profile of the speaker housing 1 is generally not changed due to the injection molding of the shields 2, and the shields 2 do not affect the overall profile of the speaker structure at all, so that no space inside the electronic device may be additionally occupied.

Optionally, as shown in FIG. 2, the speaker housing 1 may constitute four side walls of the speaker structure, enclosing a basic profile of the speaker structure; the shields may be embedded in the side walls of the speaker structure. FIG. 2 shows relative positions of the shields 2 and the speaker housing 1. In the present embodiment, the speaker structure includes four shields 2, which are embedded in the side walls of the speaker structure, respectively. Such a distribution manner of the shields 2 is capable of producing an effective magnetic shielding effect at a spatial position surrounding the speaker structure, so as to prevent the magnetic field generated by the magnetic circuit system from leaking from a side surface of the speaker structure.

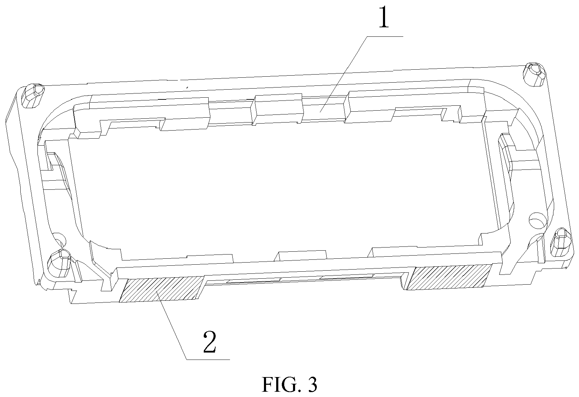

In addition, as shown in FIG. 3, the shields 2 may be mounted on an outer surface of the speaker housing 1. When the speaker housing 1 constitutes the side walls of the speaker structure, the shields 2 may be mounted on the outer surfaces of the side walls, and the shields 2 may produce a magnetic shielding effect for weakening or preventing the magnetic flux leakage phenomenon. Since the shields 2 are clung to the outer surface of the speaker housing 1, the shields 2 do not additionally occupy the space inside the electronic device. More preferably, positions on the speaker housing 1 where the shields 2 are intended to be mounted may have grooves for embedding the shields 2 from the outer surface of the speaker housing 1. The grooves may reduce a space occupied by the shields 2 outside the speaker housing 1.

Optionally, in order to facilitate injection molding in the speaker housing 1 or to mount the shields 2 on the surface of the housing, the shields 2 may be of a sheet-like structure. As shown in FIG. 1 to FIG. 3, in the embodiment of the present invention, the shields 2 are of a rectangular sheet-like structure, and the rectangular shields 2 are easily embedded in the side walls of the speaker structure. In other embodiments of the present invention, those skilled in the art can design the shields 2 in different structures and shapes according to a matching relationship between the shields 2 and the speaker housing 1.

The shields 2 are made of a magnetically conductive material easy to magnetize, and in the embodiment of the present invention, the shields 2 may be made of SPCC steel. In other embodiments of the present invention, those skilled in the art may also use other iron-carbon alloys, or iron, cobalt, nickel and alloys thereof to make the shields 2, which is not limited in the present invention so long as the material of the shields 2 is easy to magnetize and has no magnetism.

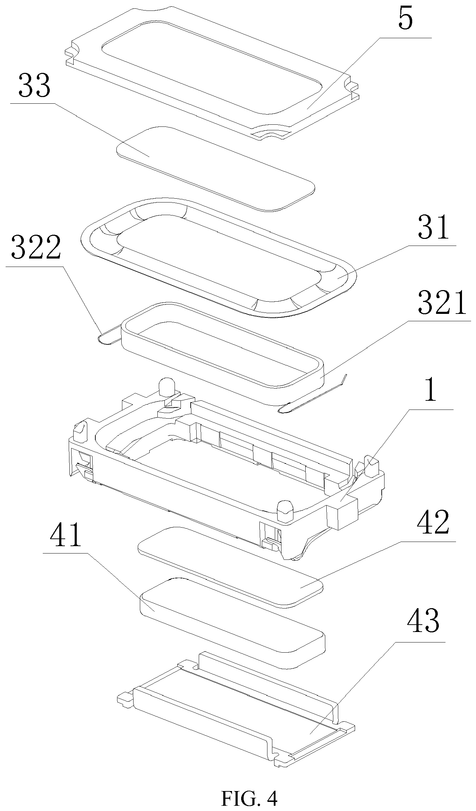

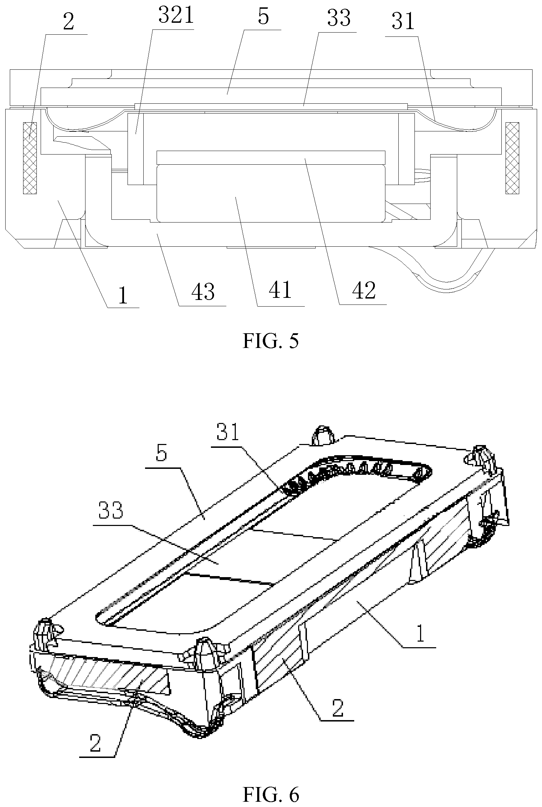

In addition, as shown in FIG. 4, the vibration assembly may include a diaphragm 31, a voice coil, and a composite layer 33, wherein an edge of the diaphragm 31 is mounted on the speaker housing 1. The voice coil includes a lead 322 and a vibration ring 321, the vibration ring 321 is mounted on the diaphragm 31, and the lead 322 is led out of the vibration ring 321. The composite layer 33 is mounted on a surface at the center of the diaphragm 31. The lead 322 is mounted on the speaker housing 1 to suspend the vibration ring 321 in the speaker housing 1. The magnetic circuit system may include a center magnet 41, a center wafer 42, and a basin frame 43. The basin frame 43 is configured to carry the center magnet 41 and the center wafer 42, the center magnet 41 and the center washer 42 are sequentially mounted in the basin frame 43, and the basin frame 43 is fixedly connected to the bottom of the speaker housing 1. There is a magnetic gap among the center magnet 41, the center washer 42 and the basin frame 43, and the vibration ring 321 is suspended in the magnetic gap. As shown in FIG. 5 and FIG. 6, after the speaker structure of the present invention is assembled, the shields 2 surround the magnetic circuit system, so that a magnetic shielding effect may be produced on the side surface of the speaker structure, the magnetic field is effectively enclosed in the speaker housing 1, and the magnetic flux leakage phenomenon is weakened or prevented. In addition, the shields 2 are formed within the space of the speaker structure without additionally occupying more space and without affecting the space inside the electronic device where the speaker structure is mounted; and therefore the electronic device is prevented from changing in volume and shape for accommodating the speaker structure.

In particular, as shown in FIG. 4 to FIG. 6, the speaker structure may further include a front cover 5 fixedly mounted on the top of the speaker housing 1 to enclose the vibration assembly in the speaker housing 1. Optionally, the front cover 5 may also be made of a magnetically conductive material, for example, SPCC steel or iron, cobalt, nickel and alloys thereof. The front cover 5 may also serve as the shield 2 for preventing the magnetic field generated by the magnetic circuit system from leaking from a top surface of the speaker housing 1.

The foregoing is illustrative of a speaker structure provided by the present invention. Although some specific embodiments of the present invention have been demonstrated in detail with examples, it should be understood by a person skilled in the art that the above examples are only intended to be illustrative but not to limit the scope of the present invention. It should be understood by a person skilled in the art that the above embodiments can be modified without departing from the scope and spirit of the present invention. The scope of the present invention is defined by the attached claims.

## Claims

1. A speaker structure, **characterized in that** it comprises:
a vibration assembly;
a magnetic circuit system;
a speaker housing (1), which is configured to carry the vibration assembly and the magnetic circuit system; and
shields (2), which are disposed on the speaker housing (1); wherein
the shields (2) are formed of a magnetically conductive material to form a magnetic shield around the speaker structure.

2. The speaker structure according to claim 1, **characterized in that**, the shields (2) are embedded inside the speaker housing (1) and/or mounted on an outer surface of the speaker housing (1).

3. The speaker structure according to claim 1, **characterized in that**, the speaker housing (1) constitutes side walls surrounding the speaker structure.

4. The speaker structure according to claim 3, **characterized in that**, the shields (2) are embedded inside the side walls and/or mounted on outer surfaces of the side walls.

5. The speaker structure according to any one of claims 1 to 4, **characterized in that**, the shields (2) are of a rectangular sheet-like structure.

6. The speaker structure according to any one of claims 1 to 4, **characterized in that**, the shields (2) are made of an SPCC material.

7. The speaker structure according to any one of claims 1 to 4, **characterized in that**, the vibration assembly comprises:
a diaphragm (31), edges of which are mounted on the speaker housing (1);
a voice coil, which includes a lead (322) and a vibration ring (321), wherein the vibration ring (321) is fixedly connected to the diaphragm (31); and
a composite layer (33), which is mounted on the diaphragm (33), wherein
the lead (322) is mounted on the speaker housing (1) to suspend the vibration ring (321) in the speaker housing (1).

8. The speaker structure according to any one of claims 1 to 4, **characterized in that**, the magnetic circuit system comprises:
a center magnet (41);
a center washer (42), which is mounted on the center magnet (41); and
a basin frame (43), which is configured to carry the center magnet (41) and the central washer (42), wherein the basin frame (43) is fixedly connected to the speaker housing (1).

9. The speaker structure according to any one of claims 1 to 4, **characterized in that**, the speaker structure comprises a front cover (5) fixedly mounted on the speaker housing (1) to enclose the vibration assembly in the speaker housing (1).

10. The speaker structure according to claim 9, **characterized in that**, the front cover (5) is made of a magnetically conductive material.
